Europäisches Patentamt

European Patent Office

Office européen des brevets

(19)

(11) Veröffentlichungsnummer: **0 288 848**

**A1**

(12) **EUROPÄISCHE PATENTANMELDUNG**

(21) Anmeldenummer: 88106104.8

(22) Anmeldetag: 16.04.88

(51) Int. Cl.4: **B23K 35/362 , H05K 3/34 ,**
**//C09K5/00**

(30) Priorität: 29.04.87 DE 3714268

(43) Veröffentlichungstag der Anmeldung:
02.11.88 Patentblatt 88/44

(84) Benannte Vertragsstaaten:
**DE ES FR GB IT NL**

(71) Anmelder: **BASF Aktiengesellschaft**
**Carl-Bosch-Strasse 38**
**D-6700 Ludwigshafen(DE)**

(72) Erfinder: **Glaser, Klaus**
**Neuweg 14**
**D-6704 Mutterstadt(DE)**
Erfinder: **Tschang, Chung-Ji, Dr.**
**Hinterbergstrasse 31**
**D-6702 Bad Duerkheim(DE)**
Erfinder: **Winkler, Ekhard, Dr.**
**Pfalzring 74**
**D-6704 Mutterstadt(DE)**
Erfinder: **Gotsmann, Guenther, Dr.**
**Max-Beckmann-Strasse 15**
**D-6710 Frankenthal(DE)**
Erfinder: **Trapp, Horst, Dr.**
**Johann-Sebastian-Bach-Strasse 10 a**
**D-6831 Plankstadt(DE)**

(54) Alkylenoxid-Addukte als Flussmittel und Umschmelzflüssigkeiten bei der Herstellung von
Leiterplatten.

(57) Die Erfindung betrifft Alkylenoxid-Addukte mehrwertiger Alkohole als Flußmittel und Umschmelzflüssigkeiten bei der Herstellung von Leiterplatten.

**EP 0 288 848 A1**

## Alkylenoxid-Addukte als Flußmittel und Umschmelzflüssigkeiten bei der Herstellung von Leiterplatten

Die Erfindung betrifft die Verwendung von Alkylenoxid-Addukten mehrwertiger Alkohole als Flußmittel und Umschmelzflüssigkeiten bei der Herstellung von Leiterplatten und diese enthaltende Flußmittel und Umschmelzflüssigkeiten und ein Verfahren zur Herstellung von Leiterplatten mit Hilfe dieser Flußmittel und Umschmelzflüssigkeiten.

Bei der Herstellung von Leiterplatten ist es erforderlich, die Leiterbahnen vor Korrosion zu schützen, um an den Stellen, an welchen Bauteile aufgelötet werden sollen, eine gute Lötbarkeit der Kontaktflächen oder Lötaugen sicherzustellen. Hierzu werden die Leiterbahnen üblicherweise mit einem Überzug aus einer Zinn-Blei-Legierung (Lot) versehen. Dies kann nach zwei üblichen und dem Fachmann bekannten Vorgehensweisen geschehen:

Bei der Herstellung von Leiterplatten nach dem Subtraktionsverfahren wird eine Zinn-Blei-Legierung auf den späteren Leiterbahnen galvanisch auf Kupfer abgeschieden. Dann wird die nicht benötigte Kupfer-Fläche abgeätzt, wobei die Zinn-Blei-Legierung als Ätzresist dient. Man erhält hierbei Kupfer-Leiterbahnen, deren Oberfläche durch die Zinn-Blei-Schicht geschützt ist und deren Flanken jedoch ungeschützt sind. Durch eine thermische Nachbehandlung wird nun bewirkt, daß die Zinn-Blei-Legierung schmilzt und auch die Flanken der Kupfer-Bahnen bedeckt. Um das zu erreichen, wird die Leiterplatte entweder in eine Flüssigkeit getaucht, deren Temperatur über dem Schmelzpunkt der Zinn-Blei-Legierung liegt oder die Leiterplatte wird mit einer Flüssigkeit benetzt und dann unter Einwirkung von z.B. Infrarot-Strahlung als Wärmequelle auf die zum Umschmelzen erforderliche Temperatur erhitzt. Die in diesen Fällen verwendeten Flüssigkeiten werden als Umschmelzflüssigkeiten bezeichnet.

Gemäß dem zweiten üblichen Verfahren werden die Leiterbahnen durch eine sog. Lötstoppmaske, z.B. einen Polymerfilm, geschützt. Sie brauchen dann nicht durch eine Lot-Oberfläche geschützt zu werden. Jedoch müssen die Kontaktflächen und die Lötaugen, die nicht mit der Lötstoppmaske bedeckt sind und auf denen später die Bauteile aufgelötet werden sollen, lötbar gemacht werden. Hierzu wird die Leiterplatte kurzzeitig in geschmolzenes Lot, üblicherweise Zinn-Blei-Lot, getaucht, wobei die sog. Heiß-Verzinnung an den Stellen erfolgt, die nicht von der Lötstoppmaske bedeckt sind. Vor diesem Tauchvorgang muß die Leiterplatte in ein Flußmittel getaucht werden, das folgende Aufgaben erfüllen muß:

Das Flußmittel muß die Leiterplatten gut benetzen können. Zur Erzeugung einer blanken und oxidfreien Kupferoberfläche auf den mit Lot zu verzinnenden Flächen muß es möglich sein, daß dem Flußmittel Aktivatoren zugesetzt werden können. Das Flußmittel sollte eine gute Wärmeübertragung in der Aufheizzone der verwendeten Vorrichtung aufweisen. Weiterhin muß es Fehldepositionen von Lot auf den Lötstoppmasken unterbinden können.

Nach dem anschließenden Tauchen in das geschmolzene Lot wird der Lot-Überschuß entweder in einem Luftstrom entfernt (Hot-Air-Levelling) oder aber das Lot-Bad ist mit dem Flußmittel überschichtet und es wird in dem Flußmittel eine Strömung erzeugt, die den Lot-Überschuß entfernt (Hot-Oil-Levelling).

Daraus ist ersichtlich, daß ein zweckmäßiges Flußmittel eine ganze Reihe von Funktionen zu erfüllen hat.

Die in der Technik verwendeten Umschmelzflüssigkeiten und Flußmittel, in der Regel sind es organische Flüssigkeiten, sollen von den Leiterplatten ohne Probleme abgewaschen werden können. Sie müssen thermisch beständig sein und sollten bei hohen Temperaturen keine Rauchgase oder toxische Gase abgeben oder Zersetzungsprodukte bilden. Sie müssen schwer entflammbar sein. Darüber hinaus sollen sie die Leiterplatten gut benetzen können. Sie sollen zweckmäßigerweise löslich oder mischbar in Wasser sein und verträglich mit Zusätzen, beispielsweise mit den auf Kupfer reduzierend wirkenden Aktivatoren. Sie sollen im Abwasser möglichst nicht schaumbildend sein und eine gute biologische Abbaubarkeit aufweisen.

Während beim Umschmelzen in einem Bad durch die relativ langen Standzeiten die thermische Stabilität und das Nichtauftreten von festen, unlöslichen Zersetzungsprodukten von besonderer Wichtigkeit ist, muß bei den Flußmitteln bevorzugt darauf geachtet werden, daß Fehldepositionen von Lot vermieden werden und daß die Viskosität den apparativen Erfordernissen angepaßt werden kann.

Für die oben genannten Aufgaben werden üblicherweise Umschmelzöle und Flußmittel auf der Basis von Alkylphenolethoxylaten oder Polyethylenglykolen bzw. Ethylenglykol-Propylenglykol-Blockcopolymerisaten verwendet, die jedoch eine Reihe von Nachteilen aufweisen. So entstehen aus Nonylphenolethoxylaten im Abwasser fischtoxische Abbauprodukte. Darüber hinaus bilden Alkylphenolethoxylate beim Mischen mit Wasser innerhalb gewisser Konzentrationen Gele und sind deshalb nur schwer von der Leiterplatte abzuwaschen. Produkte auf der Basis von Polyethylenglykol oder Ethylenglykol-Propylenglykol-Blockcopolymerisaten dagegen werden bei Temperaturen um 200°C relativ stark abgebaut und führen deshalb zu

erheblicher Rauch-und Geruchsbelästigung. Die DE-OS 27 41 312 beispielsweise beschreibt Flußmittel auf der Basis von Blockcopolymeren aus Polyoxyethylen und Polyoxypropylen und/oder Trimethylolalkan-Derivaten davon. Solche Polymere sind als Umschmelzflüssigkeiten nicht hinreichend temperaturstabil und bilden beim Mischen mit Wasser teilweise ebenfalls Gele, was ihre Abwaschbarkeit von der Leiterplatte beeinträchtigt.

In der DE-PS 27 39 577 werden Alkylenoxid-Addukte, hergestellt aus 5 bis 20 Mol Ethylenoxid und 3-bis 6-wertigen aliphatischen Alkoholen mit 3 bis 6 C-Atomen, als Wärmeübertragungsmittel, und zwar als reine Heizbadflüssigkeiten, beschrieben.

Aufgabe der vorliegenden Erfindung ist es, neue Flußmittel und Umschmelzflüssigkeiten, die bei der Herstellung von Leiterplatten verwendet werden können und die die o.g. Aufgaben erfüllen, der Technik zur Verfügung zu stellen.

Es wurde nun gefunden, daß durch die Verwendung von Alkylenoxid-Addukten, erhalten durch Umsetzung von 3-bis 6-wertigen aliphatischen Alkoholen mit 3 bis 10 C-Atomen, bevorzugt 3 bis 6 C-Atomen, mit 2 bis 7 Mol Alkylenoxid, bevorzugt 3 bis 5 Mol Alkylenoxid, mit 2 bis 4 C-Atomen je alkoholischer Gruppe pro Mol aliphatischen Alkohol, wobei der Gehalt an Ethylenoxid, bezogen auf die Gesamtmenge an Alkylenoxid, 60 bis 100 Mol% beträgt, als Grundstoff für Flußmittel und Umschmelzflüssigkeiten bei der Herstellung von Leiterplatten die obengenannten Erfordernisse erfüllt werden können.

Gegenstand der Erfindung sind auch Verfahren zum Umschmelzen von Zinn-Blei-Legierungen bei der Herstellung von Leiterplatten in an sich üblicher Weise, bei denen man eine Umschmelzflüssigkeit auf Basis der o.g. Alkylenoxid-Addukte einsetzt, sowie Verfahren zur Heißverzinnung von Leiterplatten in üblicher Weise, bei denen man vor der Heißverzinnung die Leiterplatten mit einem Flußmittel auf Basis der o.g. Alkylenoxid-Addukte behandelt.

Im Falle des Einsatzes als Flußmittel ist unter Behandeln beispielsweise Tauchen, Sprühen oder Auftragen mit Walzen zu verstehen. In der Regel werden umgerechnet auf m² Oberfläche etwa 30 bis 100 g aufgetragen.

Gegenstand der Erfindung sind auch Flußmittel und Umschmelzflüssigkeiten, enthaltend als Grundbestandteil die oben beschriebenen Alkylenoxid-Addukte neben an sich üblichen Zusätzen.

Die erfindungsgemäß zu verwendenden Alkylenoxid-Addukte sind aufgebaut im Hinblick auf die Alkylenoxideinheiten ausschließlich aus Ethylenoxid oder aus Ethylenoxid zusammen mit Propylenoxid und/oder Butylenoxid. Dabei beträgt der Anteil an Propylenoxid und/oder Butylenoxid höchstens 30 Mol%, bezogen auf die Gesamtmenge an Alkylenoxid.

Der bevorzugte Anteil an Propylenoxid und/oder Butylenoxid kann auch durch die folgende Gleichung dargestellt werden:

$(A + 2B) \geqq 30$ Mol%, wobei A Mol% Propylenoxid und B Mol% Butylenoxid, bezogen auf die Gesamtmenge Alkylenoxid, bedeuten und A einen Wert von 0 bis 30 und B einen Wert von 0 bis 15 darstellen. Für den bevorzugten

Bereich ergibt sich für A eine Obergrenze von 30 Mol% und für B eine von 15 Mol%.

Bei den mehrwertigen Alkoholen handelt es sich bevorzugt um Glycerin und Trimethylolpropan, um Pentite, insbesondere Pentaerythrit, und Hexite, insbesondere Sorbit, wobei eine Umsetzung mit 3 bis 5 Mol Alkylen oxid je alkoholische Gruppe besonders hervorzuheben ist.

Die Herstellung der erfindungsgemäß zu verwendenden Alkylenoxid-Addukteist bekannt und bedarf keiner näheren Erläuterung. Bei der Verwendung verschiedener Alkylenoxide liegen diese in statistischer Verteilung vor.

Im einzelnen wird noch ausgeführt:

Wenn bei der Verwendung eine besonders hohe thermische Stabilitätgefordert wird, sind Umsetzungsprodukte ausschließlich mit Ethylenoxidbevorzugt. Ganz besonders hervorzuheben sind dann Addukte mit 3 bis 4 Mol Ethylenoxid pro alkolischer Gruppe pro Mol Ausgangsalkohol.

Wenn auf eine besonders gute Benetzung der Leiterplatten Wert gelegt wird, ist es vorteilhaft, Alkylenoxid-Mischungen zu verwenden, bevorzugt z.B. eine Mischung mit 3 bis 5 Mol Alkylenoxid pro alkoholischer Gruppe bestehend aus 85 bis 95 Mol% Ethylenoxid und 15 bis 5 Mol% Propylenoxid.

Durch die Auswahl des zugrundeliegenden Alkohols kann die Viskosität des Alkylenoxid-Adduktes variiert werden. Mit Glycerin und Trimethylolpropanwerden niedrigere, mit Pentaerythrit und Sorbit werden beispielsweise höhere Viskositäten erzielt.

Wie oben angegeben, zeichnen sich die erfindungsgemäß zu verwendenden Addukte besonders durch ihre thermische Beständigkeit, durch die allenfalls minimale Bildung unlöslicher Verkohlungsprodukte, durch beliebige Mischbarkeit mit Wasser, durch hervorragende Abwaschbarkeit von der Leiterplatte sowie durch Schaumarmut und biologische Abbaubarkeit im Abwasser aus. Sie können allein oder in Mischung untereinander eingesetzt werden. Wegen der guten Mischbarkeit ist auch der Einsatz in Mischung mit anderen Mitteln möglich.

Bei der praktischen Verwendung der Alkylenoxid-Addukte, dabei kommen vorteilhaft auch Mischungen der erfindungsgemäß zu verwendenden Alkylenoxid-Addukte in Betracht, als Flußmittel und Umschmelzflüssigkeiten enthalten diese als üblichen Zusätze, z.B. einem Tensid und die üblichen Aktivatoren. Als Tenside werden zweckmäßigerweise $C_5$-bis $C_{12}$-Alkylphenolethoxylate mit 5 bis 20 Mol Ethylenoxid verwendet. Bei den Aktivatoren handelt es sich beispielsweise um Säurehalogenide organischer Säuren, um Hydrochloride oder Hydrobromide vo aliphatischen geradkettigen oder cyclischen Aminen, wie Triethylamin oder Morpholin, um Aminosäuren, wie Glutaminsäure oder Glycin, ggf. um Chlor-oder Bromwasserstoff selbst sowie um aliphatische einbasige bis dreibasige Carbonsäuren, ggf. durch Hydroxylreste substituiert, wie Essigsäure, Oxalsäure, Bernsteinsäure, Adipinsäure, Milchsäure, Weinsäure oder Zitronensäure. Diese können ggf. in Form von wäßrigen Lösungen zugesetzt werden. Bei einem Einsatz als Umschmelzflüssigkeit im Bad muß wegen der hohen Temperaturen selbstverständlich mit einem wasserfreien Aktivator gearbeitet werden. Gegebenenfalls kann eine Verdünnung mit einem leichtflüchtigen Lösemittel, z.B. Isopropanol, erfolgen, insbesondere wenn man nach dem IR-Umschmelzverfahren arbeitet. Dabei können 30 bis 65 Gew.% Isopropanol, bezogen auf die Gesamtmenge, vorteilhaft sein.

Als beispielhafte Zusammensetzungen für Flußmittel und Umschmelzflüssigkeiten werden angegeben:

1. Flußmittel für die Heiß-Verzinnung mit Hot-Air-Levelling:

72 bis 95 Gew.% erfindungsgemäß zu verwendendes Alkylenoxid-Addukt

0 bis 23 Gew.%, bevorzugt 10 bis 20 Gew.%, Tensid

0,2 bis 3,5 Gew.%, bevorzugt 1 bis 2 Gew.% Aktivator (wasserfrei) und

4,8 bis 26 Gew.%, bevorzugt 10 bis 20 Gew.%, Wasser.

2. Flußmittle für die Heiß-Verzinnung mit Hot-Air-Levelling oder Umschmelzflüssigkeit für Umschmelzen im Bad:

75 bis 100 Gew.%, bevorzugt 70 bis 100 Gew.%, erfindungsgemäß zu verwendendes Alkylenoxid-Addukt,

0 bis 25 Gew.% Tensid und

0 bis 2,5 Gew.%, bevorzugt 0,1 bis 1,5 Gew.% Aktivator (wasserfrei).

3. Umschmelzflüssigkeit für das IR-Umschmelzverfahren:

35 bis 70 Gew.%, bevorzugt 45 bis 60 Gew.% erfindungsgemäß zu verwendendes Alkylenoxid-Addukt

0 bis 40 Gew.%, bevorzugt 0 bis 15 Gew.%, Tensid

0,1 bis 2,5 Gew.%, bevorzugt 0,2 bis 1,2 Gew.%, Aktivator (wasserfrei),

0 bis 20 Gew.%, bevorzugt 0 bis 10 Gew.%, Wasser und

30 bis 65 Gew.%, bevorzugt 40 bis 50 Gew.%, Isopropanol.

Anwendungsbeispiele:

1. Verwendet wird eine Mischung aus 80 Gew.-Teilen eines Umsetzungsproduktes aus 1 Mol Glycerin mit 11 Mol Ethylenoxid, 3,5 Gew.-Teilen Glycinhydrochlorid und 16,5 Gew.-Teilen Wasser als Flußmittel für die Heiß-Verzinnung unter Verwendung von Hot-Air-Levelling.

2. Verwendet wird eine Mischung aus 60 Gew.-Teilen eines Umsetzungsproduktes aus 1 Mol Glycerin mit 11 Mol Ethylenoxid, 20 Gew.-Teilen eines Umsetzungsproduktes aus 1 Mol Sorbit und 22 Mol Ethylenoxid, 2 Gew.-Teilen Glutaminsäurehydrochlorid, 3 Gew.-Teilen konzentrierte Salzsäure (30 gew.%ig) und Rest zu 100 Gew.-Teilen Wasser als Flußmittel für die Heiß-Verzinnung unter Anwendung von Hot-Air-Levelling.

3. Verwendet wird eine Mischung aus 31 Gew.-Teilen eines Umsetzungsproduktes aus 1 Mol Glycerin mit 11 Mol Ethylenoxid, 60 Gew.-Teilen Isopropanol, 5 Gew.-Teilen Wasser, 3 Gew.-Teilen Triethanolamin-hydrobromid und 1 Gew.-Teil Nonylphenolethoxylat mit 10 Mol Ethylenoxid als Umschmelzmittel für Infrarot-Umschmelzung.

## Ansprüche

1. Verwendung von Alkylenoxid-Addukten, erhalten durch Umsetzung von 3-bis 6-wertigen aliphatischen Alkoholen mit 3 bis 10 C-Atomen mit 2 bis 7 Mol Alkylenoxid mit 2 bis 4 C-Atomen je alkoholischer Gruppe pro Mol aliphatischer Alkohol, wobei der Gehalt an Ethylenoxid, bezogen auf die Gesamtmenge an Alkylenoxid, 60 bis 100 Mol% beträgt, als Grundstoff für Flußmittel und Umschmelzflüssigkeiten bei der Herstellung von Leiterplatten.

2. Verwendung von Alkylenoxid-Addukten nach Anspruch 1, erhalten durch Umsetzung von 3-bis 6-wertigen aliphatischen Alkoholen mit 3 bis 6 C-Atomen mit 2 bis 7 Mol Ethylenoxid oder mit 2 bis 7 Mol Ethylenoxid und Propylenoxid und/oder Butylenoxid mit einem Anteil von höchstens 30 Mol% an Propylenoxid und/oder Butylenoxid, bezogen auf die Gesamtmenge an Alkylenoxid, je alkoholischer Gruppe pro Mol aliphatischer Alkohol.

3. Verwendung von Alkylenoxid-Addukten nach Anspruch 1 oder 2, erhalten durch Umsetzung von Glycerin, Trimethylolpropan, Pentaerythrit oder Sorbit mit 3 bis 5 Mol Ethylenoxid pro alkoholischer Gruppe pro Mol Alkohol oder mit 3 bis 5 Mol Alkylenoxid in Form von 85 bis 95 Mol% Ethylenoxid und 15 bis 5 Mol% Propylenoxid.

4. Verfahren zum Umschmelzen von Zinn-Blei-Legierungen bei der Herstellung von Leiterplatten in üblicher Weise, dadurch gekennzeichnet, daß man eine Umschmelzflüssigkeit auf Basis von Alkylenoxid-Addukten, erhalten durch Umsetzung von 3-bis 6-wertigen aliphatischen Alkoholen mit 3 bis 10 C-Atomen mit 2 bis 7 Mol Alkylenoxid mit 2 bis 4 C-Atomen je alkoholischer Gruppe pro Mol aliphatischer Alkohol, wobei der Gehalt an Ethylenoxid, bezogen auf die Gesamtmenge an Alkylenoxid, 60 bis 100 Mol% beträgt, einsetzt.

5. Verfahren nach Anspruch 4, dadurch gekennzeichnet, daß man eine Umschmelzflüssigkeit auf Basis von Alkylenoxid-Addukten, erhalten durch Umsetzung von 3-bis 6-wertigen aliphatischen Alkoholen mit 3 bis 6 C-Atomen mit 2 bis 7 Mol Ethylenoxid oder mit 2 bis 7 Mol Ethylenoxid und Propylenoxid und/oder Butylenoxid mit einem Anteil von höchstens 30 Mol% an Propylenoxid und/oder Butylenoxid, bezogen auf die Gesamtmenge an Alkylenoxid, je alkoholischer Gruppe pro Mol aliphatischer Alkohol, einsetzt.

6. Verfahren nach Anspruch 4 oder 5, dadurch gekennzeichnet, daß man eine Umschmelzflüssigkeit auf Basis von Alkylenoxid-Addukten, erhalten durch Umsetzung von Glycerin, Trimethylolpropan, Pentaerythrit oder Sorbit mit 3 bis 5 Mol Ethylenoxid pro alkoholischer Gruppe pro Mol Alkohol oder mit 3 bis 5 Mol Alkylenoxid in Form von 85 bis 95 Mol% Ethylenoxid und 15 bis 5 Mol% Propylenoxid, einsetzt.

7. Verfahren zur Heiß-Verzinnung von Leiterplatten in üblicher Weise, dadurch gekennzeichnet, daß man vor der Heiß-Verzinnung die Leiterplatten mit einem Flußmittel auf Basis von Alkylenoxid-Addukten, erhalten durch Umsetzung von 3-bis 6-wertigen aliphatischen Alkoholen mit 3 bis 10 C-Atomen mit 2 bis 7 Mol Alkylenoxid mit 2 bis 4 C-Atomen je alkoholischer Gruppe pro Mol aliphatischer Alkohol, wobei der Gehalt an Ethylenoxid, bezogen auf die Gesamtmenge an Alkylenoxid, 60 bis 100 Mol% beträgt, behandelt.

8. Verfahren nach Anspruch 7, dadurch gekennzeichnet, daß man die Leiterplatten mit einem Flußmittel auf Basis von Alkylenoxid-Addukten, erhalten durch Umsetzung von Glycerin, Trimethylolpropan, Pentaerythrit oder Sorbit mit 3 bis 5 Mol Ethylenoxid pro alkoholischer Gruppe pro Mol Alkohol oder mit 3 bis 5 Mol Alkylenoxid in Form von 85 bis 95 Mol% Ethylenoxid und 15 bis 5 Mol% Propylenoxid, behandelt.

9. Verfahren nach Anspruch 7 oder 8, dadurch gekennzeichnet, daß man die Leiterplatten mit einem Flußmittel auf Basis von Alkylenoxid-Addukten, erhalten durch Umsetzung von Glycerin, Trimethylolpropan, Pentaerythrit oder Sorbit mit 3 bis 5 Mol Ethylenoxid pro alkoholischer Gruppe pro Mol Alkohol oder mit 3 bis 5 Mol Alkylenoxid in Form von 85 bis 95 Mol% Ethylenoxid und 15 bis 5 Mol% Propylenoxid, behandelt.

10. Flußmittel und Umschmelzflüssigkeiten für die Herstellung von Leiterplatten, im wesentlichen bestehend aus Alkylenoxid-Addukten, wie in den Ansprüchen 1 bis 3 definiert, und an sich üblichen Zusätzen.

## EUROPÄISCHER RECHERCHENBERICHT

| | EINSCHLÄGIGE DOKUMENTE | | EP 88106104.8 |
|---|---|---|---|

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| X | <u>EP - A1 - 0 173 167</u> (TEXACO DEVELOPMENT CORPORATION) <br><br> * Seite 1, Zeilen 5-22; Seite 4; Ansprüche 1-4 * <br><br> -- | 1-3 | B 23 K 35/362 <br> H 05 K 3/34 <br> //C 09 K 5/00 |
| X | <u>DE - A1 - 2 741 312</u> (INTERNATIONAL BUSINESS MACHINES CORP.) <br><br> * Seite 5, insbesondere Zeilen 1-3; Ansprüche * <br><br> -- | 1-3 | |
| A | <u>DE - B - 1 934 122</u> (OLIN CORP.) <br><br> * Spalte 3, Zeilen 14-29; Ansprüche * <br><br> ---- | 1-3,10 | |

| RECHERCHIERTE SACHGEBIETE (Int. Cl.4) |
|---|
| B 23 K <br> H 05 K <br> C 09 K |

Der vorliegende Recherchenbericht wurde für alle Patentansprüche erstellt.

| Recherchenort | Abschlußdatum der Recherche | Prüfer |
|---|---|---|
| WIEN | 18-07-1988 | SLAMA |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82